(19) Europäisches Patentamt / European Patent Office / Office européen des brevets

(11) **EP 3 057 311 B1**

(12) **FASCICULE DE BREVET EUROPEEN**

(45) Date de publication et mention
de la délivrance du brevet:
**02.09.2020 Bulletin 2020/36**

(51) Int Cl.:
*H04N 5/3745* *(2011.01)*  *H03F 3/08* *(2006.01)*
*H04N 5/335* *(2011.01)*  *H04N 5/378* *(2011.01)*
*H03F 3/45* *(2006.01)*

(21) Numéro de dépôt: **16155440.7**

(22) Date de dépôt: **12.02.2016**

(54) **DISPOSITIF DE DÉTECTION AMÉLIORÉ**

VERBESSERTE DETEKTIONSVORRICHTUNG

IMPROVED DETECTION DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.02.2015 FR 1551132**

(43) Date de publication de la demande:
**17.08.2016 Bulletin 2016/33**

(73) Titulaire: **LYNRED
91120 Palaiseau (FR)**

(72) Inventeur: **Salvetti, Frédéric
38330 Montbonnot (FR)**

(74) Mandataire: **Talbot, Alexandre et al
Cabinet Hecké
28 Cours Jean Jaurès
38000 Grenoble (FR)**

(56) Documents cités:
**EP-B1- 0 845 687      FR-A1- 2 593 319
US-A- 6 097 021      US-A1- 2013 264 490
US-A1- 2014 061 488**

## Description

## Domaine de l'invention

L'invention est relative à un dispositif de détection amélioré.

## Etat de la technique

Dans de nombreuses activités, une scène est observée par un dispositif de détection qui comporte un photodétecteur. Le photodétecteur reçoit un signal lumineux qu'il transforme en un signal électrique représentatif de la scène observée.

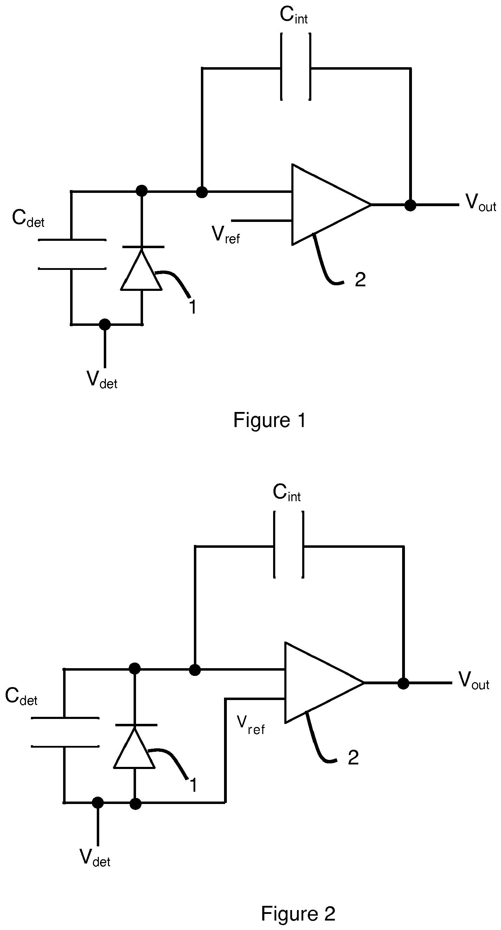

Dans un mode de réalisation conventionnel illustré à la figure 1, le photodétecteur 1 est une photodiode qui comporte un condensateur parasite $C_{det}$ monté en parallèle du photodétecteur 1.

Le photodétecteur 1 est relié à un circuit de lecture de type amplificateur transimpédance capacitif ou CTIA en langue anglaise pour Capacitive TransImpedance Amplifier.

Le circuit de lecture comporte un amplificateur 2 dont une entrée est reliée au photodétecteur 1. L'autre entrée de l'amplificateur 2 est reliée à une source de tension qui applique la tension $V_{ref}$. La sortie de l'amplificateur 2 délivre un signal en tension $V_{out}$ représentatif du signal en courant délivré par le photodétecteur 1.

Un condensateur d'intégration Cint est connecté à l'amplificateur dans un montage en contre-réaction, c'est-à-dire qu'il connecte la borne de sortie et la borne connectée au photodétecteur.

La demande de brevet US 2013/264490 A1 divulgue un tel dispositif de détection.

Cependant, dans ce type d'architecture, il est observé un bruit sur la borne de sortie qui vient parasiter le signal électrique représentatif de la scène observée.

Le rapport signal sur bruit est particulièrement défavorable dans les dispositifs de détection qui présentent des photodétecteurs de taille importante et qui sont configurés pour détecter un très faible flux, c'est-à-dire que le condensateur d'intégration présente une faible capacité électrique et une forte capacité du détecteur.

## Objet de l'invention

L'invention a pour objet un dispositif de détection qui présente un rapport signal sur bruit amélioré.

On tend à atteindre ce résultat au moyen d'un dispositif de détection comportant :

- un photodétecteur configuré pour transformer un signal électromagnétique en un signal électrique représentatif,
- un amplificateur ayant une première borne d'entrée connectée à une première borne du photodétecteur,
- un condensateur d'intégration connecté à la borne de sortie de l'amplificateur et à la première borne d'entrée de l'amplificateur,
- une première source de tension configurée pour délivrer une tension de référence à une deuxième borne d'entrée de l'amplificateur,
- une deuxième source de tension configuré pour délivrer une tension de détecteur à une deuxième borne du photodétecteur,

Le dispositif de détection est remarquable en ce que les première et deuxième sources de tension sont corrélées de manière à corréler les composantes de bruit. De cette manière certaines composantes de bruit s'annulent.

Il est particulièrement avantageux de prévoir que l'amplificateur est déséquilibré de sorte que la tension sur la première borne d'entrée de l'amplificateur soit décalée de la tension sur la deuxième borne d'entrée de l'amplificateur d'une différence de tension au moins égale à 20mV. Ainsi, les aléas de réalisation ont un effet négligeable sur la conversion du signal lumineux en un signal électrique. De préférence, la différence de tension est comprise entre 50 et 100mV pour réduire encore plus les effets du procédé de réalisation sur un très grand nombre de photodétecteurs et de circuits de lecture.

Il est également intéressant de prévoir que l'amplificateur comporte un miroir de courant muni de deux branches montées en dérivation, l'une des branches présentant des performances électriques différentes de l'autre branche. Ainsi, il est possible facilement de réaliser un amplificateur déséquilibré.

Dans un cas particulier, l'une des branches du miroir de courant comporte plusieurs transistors additionnels montés en parallèles d'un transistor principal, les transistors additionnels et le transistor principal recevant tous le même signal sur leur électrode de commande. Dans un mode de réalisation plus précis, l'une des branches du miroir de courant comporte plusieurs interrupteurs de connexion connectés pour autoriser ou bloquer le passage d'un courant depuis chaque transistor additionnel associé.

Dans un autre cas particulier, les première et deuxième bornes d'entrée sont connectées respectivement à des électrodes de commande de premier et deuxième transistors et les premier et deuxième transistors présentent des performances électriques différentes.

Dans un mode de réalisation plus précis, il est possible de prévoir que les première et deuxième bornes d'entrée sont connectées respectivement à des électrodes de commande de premier et deuxième transistors et que plusieurs transistors additionnels sont montés en parallèle du premier transistor, les transistors additionnels recevant sur leurs électrodes de commande le même signal que le premier transistor.

Il est encore possible de prévoir que les transistors additionnels sont montés en parallèles au moyen de plusieurs interrupteurs de connexion connectés pour autoriser ou bloquer le passage d'un courant depuis chaque transistor additionnel associé.

Dans un mode de réalisation particulier, la première source de tension est la deuxième source de tension de sorte que la tension de référence est égale à la tension de détecteur.

Dans un autre mode de réalisation particulier, la première source de tension et la deuxième source de tension sont formées au moyen d'une source de tension initiale alimentant un pont résistif délivrant la tension de référence et la tension de détecteur différente de la tension de référence.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente, de manière schématique, un circuit de détection de l'art antérieur,
- la figure 2 représente, de manière schématique, un premier mode de réalisation d'un circuit de détection,
- la figure 3 représente, de manière schématique, un premier mode de réalisation d'un amplificateur opérationnel d'un circuit de détection,
- les figures 4 et 5 représentent, de manière schématique, des modes de réalisation d'un amplificateur opérationnel avec déséquilibre du miroir de courant,
- les figures 6 et 7 représentent, de manière schématique, des modes de réalisation d'un amplificateur opérationnel avec déséquilibre des branches recevant les signaux d'entrée,
- la figure 8 représente, de manière schématique, un autre mode de réalisation d'un circuit de détection.

**Description détaillée**

La figure 2 illustre un premier mode de réalisation d'un circuit de détection.

Le circuit de détection comporte un photodétecteur 1 qui est préférentiellement une photodiode. Le photodétecteur comporte un condensateur parasite $C_{det}$ monté en parallèle du photodétecteur 1. Le photodétecteur génère un courant représentatif de la scène observée. Le photodétecteur peut être configuré pour détecter des signaux dans le domaine visible ou alors dans le domaine infrarouge.

Le photodétecteur 1 est relié à un circuit de lecture de type amplificateur transimpédance capacitif ou CTIA en langue anglaise pour Capacitive TransImpedance Amplifier.

Le circuit de lecture comporte un amplificateur 2 dont une entrée est reliée au photodétecteur 1. L'autre entrée de l'amplificateur 2 est reliée à une source de tension qui applique la tension $V_{ref}$. La sortie de l'amplificateur 2 délivre un signal en tension $V_{out}$ représentatif du signal en courant délivré par le photodétecteur 1.

Un condensateur d'intégration $C_{int}$ est connecté à l'amplificateur dans un montage en contre-réaction, c'est-à-dire qu'il connecte la borne de sortie et la première borne d'entrée connectée au photodétecteur 1.

Dans une telle configuration, une composante du bruit présent sur la borne de sortie délivrant la tension $V_{out}$ peut s'écrire :

$$bruit = \left(1 + \frac{C_{det}}{C_{int}}\right).V_{ref*} - \frac{C_{det}}{C_{int}}.V_{det*}$$

Pour réduire la composante de bruit, on remarque qu'il est avantageux d'avoir égalité entre les bruits des tensions $V_{ref*}$ et $V_{det*}$ et de fournir les deux tensions au moyen de la même source de tension afin que les composantes du bruit soient corrélés et s'annulent. $V_{ref*}$ et $V_{det*}$ représentent les composantes de bruit des tension $V_{ref}$ et $V_{det}$. De cette manière, le bruit généré en sortie du circuit de lecture par les tensions de référence que sont les tensions $V_{ref}$ et $V_{det}$ est annulé. On peut également constaté que le niveau du bruit est lié au rapport des condensateurs $\frac{C_{det}}{C_{int}}$. Cependant, les valeurs de capacités électriques sont liées aux performances du dispositif et ne sont pas facilement modifiables.

Dans le mode de réalisation particulier illustré à la figure 2, la tension $V_{ref}$ et la tension $V_{det}$ sont identiques et sont fournies par la même source de tension de sorte que la composante de bruit fournie par la source de tension soit corrélée pour la tension $V_{ref}$ appliquée sur une borne de l'amplificateur et pour la tension $V_{det}$ appliquée sur une borne du photodétecteur. Dans l'exemple illustré, la tension $V_{det}$ est appliquée sur le photodétecteur et sur l'amplificateur. En d'autres termes, la première source de tension est la deuxième source de tension de sorte que la tension de référence $V_{ref}$ est égale à la tension de détecteur $V_{det}$.

Des essais ont montré que dans ce mode de réalisation, la composante de bruit est annulée ce qui améliore le rapport signal sur bruit.

Bien que ce mode de réalisation donne de bons résultats, il a été observé que dans une matrice de photodétecteurs associée à une matrice de circuits de lecture, les aléas de fabrication des circuits de lecture entrainent des différences de polarisation appliquée par l'amplificateur 2 sur la borne du photodétecteur 1. Dans certains cas, le photodétecteur 1 est polarisé en inverse, dans d'autres cas le photodétecteur 1 est polarisé en direct et il existe également des cas où la même polarisation est appliquée aux deux bornes du photodétecteur 1.

Ces variations de polarisation entrainent une différence de comportement du photodétecteur 1 lors de la transformation du signal lumineux en un signal électrique ce qui annule une partie du gain procuré par l'utilisation de la même source de tension sur le niveau de bruit.

Dans un mode de réalisation particulier, l'amplificateur opérationnel 2 est déséquilibré de manière à créer une différence de tension entre l'entrée inverseuse et l'entrée non inverseuse, c'est-à-dire entre les deux entrées de l'amplificateur.

Théoriquement, les tensions présentes sur les deux entrées de l'amplificateur opérationnel sont identiques. Par exemple, lorsque la tension $V_{ref}$ est appliquée sur la deuxième borne d'entrée de l'amplificateur 2 et si le condensateur $C_{int}$ est déchargé ou faiblement chargé, la première borne d'entrée de l'amplificateur est également à la tension $V_{ref}$ ce qui permet de polariser le photodétecteur 1. Un tel mode de réalisation est illustré à la figure 1.

Dans la pratique, lorsque plusieurs amplificateurs opérationnels sont réalisés, il existe une légère différence de tension entre les différents amplificateurs et la valeur de cette différence varie d'un amplificateur à un autre. De manière classique, la différence de tension entre les deux entrées (également appelées entrées inverseuse et non inverseuse) est inférieure à 10mV en valeur absolue. Dans un dispositif de détection qui comporte une matrice de photodétecteurs (par exemple 1000 photodétecteurs) associée à une matrice de circuits de lecture (par exemple 1000 circuits de lecture) de multiples tensions différentes de polarisation sont observées.

De manière à s'assurer un fonctionnement plus homogène des photodétecteurs, il est avantageux de déséquilibrer l'amplificateur opérationnel 2 de manière à ce que la différence entre les entrées inverseuse et non inverseuse soit supérieure ou égale à 20mV et de préférence dans la gamme 50-100mV. En d'autres termes, l'amplificateur est déséquilibré de sorte que la tension sur la première borne d'entrée de l'amplificateur soit décalée de la tension sur la deuxième borne d'entrée de l'amplificateur d'une différence de tension au moins égale à 20mV et préférentiellement dans la gamme 50-100mV. De manière préférentielle, le déséquilibre est réalisé de manière à ce que le décalage de tension soit entre trois et six fois la dispersion observée sur les transistors.

Dans ces conditions, les variations de fabrication des différents amplificateurs ne viennent pas perturber les conditions de polarisation du photodétecteur 1. De manière particulièrement avantageuse, l'amplificateur opérationnel 2 est déséquilibré de manière à ce que le photodétecteur 1 soit polarisé en inverse. Dans le cas où le photodétecteur 1 est une photodiode, cette précaution permet de placer la photodiode sur le plateau de polarisation inverse. Si une matrice de photodétecteurs 1 est utilisée en association avec une matrice de circuits de lecture, les variations de comportement liées aux variation de polarisation sont au moins partiellement gommées.

Dans ce cas de figure, bien que la tension $V_{det}$ soit appliquée sur la deuxième borne d'entrée de l'amplificateur 2, la première borne d'entrée délivre la tension $V_{ref}$.

Pour déséquilibrer un amplificateur, de nombreux modes de réalisation existent. Une manière simple est de déséquilibrer les deux branches connectées aux deux entrées de l'amplificateur. Dans de nombreux modes de réalisation, les deux branches sont montées en dérivation. Il est alors intéressant de présenter deux branches qui comportent des performances électriques différentes.

L'amplificateur comportant communément un miroir de courant muni de deux branches montées en dérivation, il est alors possible de prévoir que l'une des branches présente des performances électriques différentes de l'autre branche.

Dans un autre mode de réalisation, les première et deuxième bornes d'entrée sont connectées respectivement aux électrodes de commandes de premier et deuxième transistors T3 et T4. Le déséquilibre est introduit en utilisant des premier et deuxième transistors qui présentent des performances électriques différentes.

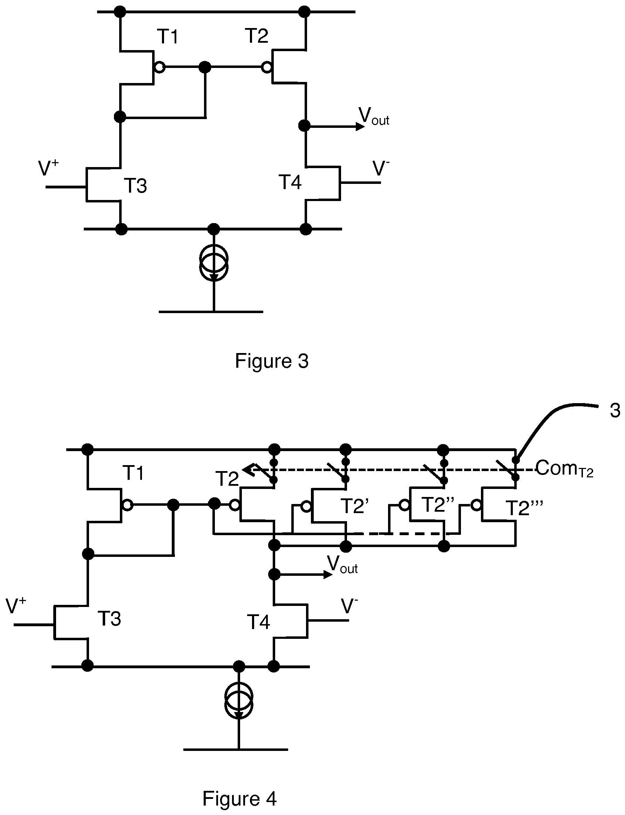

La figure 3 illustre un mode de réalisation schématique d'un amplificateur opérationnel. L'amplificateur opérationnel comporte un circuit miroir de courant formé par les transistors T1 et T2. Les entrées inverseuse et non inverseuse sont représentées par les électrodes de commandes recevant les signaux V- et V+. Le signal V+ est appliqué sur l'électrode de commande du transistor T3. Le signal V- est appliqué sur l'électrode de commande du transistor T4.

Les transistors T1 et T3 sont montés en série dans une première branche alors que les transistors T2 et T4 sont montés en série dans une deuxième branche. Les deux branches sont montées en dérivation.

Pour réaliser une différence de tension entre les entrées inverseuse et non inverseuse, il est possible de déséquilibrer l'amplificateur opérationnel au moyen de transistors ayant des performances électriques différentes. Alors que dans un amplificateur opérationnel classique, on utilise des transistors identiques pour les entrées inverseuse et non inverseuse, dans ce mode de réalisation les transistors sont différents entre les deux entrées. Une manière de réaliser un tel dispositif est par exemple d'utiliser des transistors ayant des tailles différentes. Les transistors T1 et T3 recevant les signaux V+ et V-, c'est-à-dire par exemple la tension $V_{det}$, ont des dimensions différentes. Il est également possible d'avoir des transistors T1 et T2 ayant des dimensions différentes. Il est encore possible d'avoir une combinaison de ces deux modes de réalisation tant que les deux branches montées en dérivation présentent des performances électriques différentes.

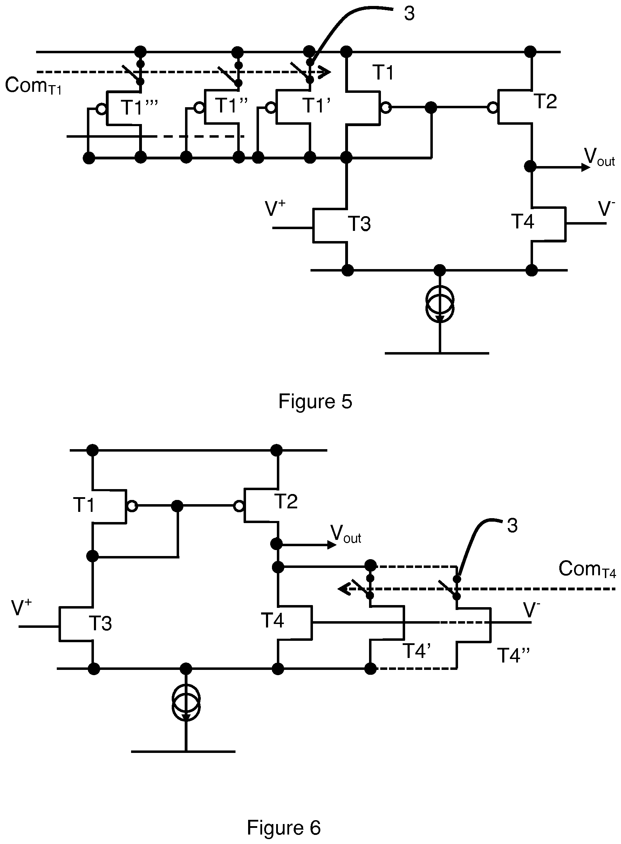

Les figures 4 et 5 illustrent deux modes de réalisation dans lesquels l'amplificateur opérationnel est déséquilibré aux moyens de miroirs de courant déséquilibrés. Dans ces cas de figure, l'une des branches du miroir de courant comporte plusieurs transistors additionnels montés en parallèles d'un transistor principal, les transistors additionnels et le transistor principal recevant tous le même signal sur leur électrode de commande. De manière plus précise, il est possible de prévoir que la branche munie des transistors additionnels comporte plusieurs interrupteurs de connexion 3 connectés pour autoriser ou bloquer le passage d'un courant depuis chaque transistor additionnel associé

Dans le mode de réalisation de la figure 4, plusieurs transistors additionnel T2', T2" et T2''' sont montés en parallèle du transistor principal T2. Les transistors reçoivent tous le même signal sur leur électrode de commande. Dans cette réalisation, les différents transistors additionnels sont chacun couplés à un interrupteur de connexion 3 qui est configuré pour autoriser ou bloquer le passage d'un courant vers la branche contenant le transistor T2. Ces différents interrupteurs de connexion 3 sont activés séparément par le signal $Com_{T2}$. Le signal ComT2 permet de choisir si un ou plusieurs transistors doivent être connectés en parallèle du transistor T2. De cette manière, il est possible de choisir la quantité de courant qui va circuler dans la branche du miroir de courant. Plus le nombre de transistors connectés est important et plus le courant délivré est grand. En modulant le nombre de transistors montés en parallèle, il est possible de moduler le déséquilibre entre les deux branches du miroir de courant.

En choisissant un transistor T1 plus grand que le transistor T2, il est possible d'avoir un déséquilibre dans un premier sens entre les deux branches du miroir de courant puis d'annuler le déséquilibre ou d'inverser le déséquilibre en augmentant le nombre de transistors montés en parallèle du transistor T2.

De manière avantageuse, les transistors T1, T2, T2', T2" et T2''' sont identiques de manière à faciliter le procédé de fabrication. Le nombre de transistors montés en série définit l'amplitude du déséquilibre.

Dans le mode de réalisation de la figure 5, le déséquilibre est réalisé sur l'autre branche du miroir de courant. Plusieurs transistors sont montés en parallèle du transistor principal T1. Les différents transistors additionnels T1', T1" et T1''' sont couplés à des interrupteurs de connexion 3 qui sont activés par le signal $Com_{T1}$. Ce qui a été expliqué pour le mode de réalisation de la figure 4 s'applique également au mode de réalisation de la figure 5 en intervertissant les transistors T1 et T2.

Il est aussi possible de combiner ces deux modes de réalisation.

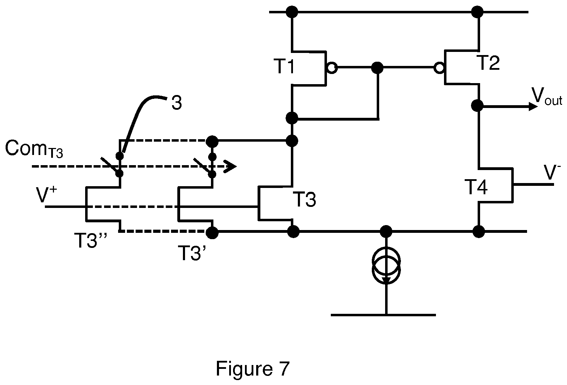

Dans une variante de réalisation, le déséquilibre est réalisé sur les transistors recevant les signaux $V^+$ et $V^-$. Les modes de réalisation des figures 6 et 7 représentent des montages permettant de facilement déséquilibrer l'amplificateur opérationnel. Dans ces modes de réalisation, les première et deuxième bornes d'entrée sont connectées respectivement aux électrodes de commande de premier et deuxième transistors et plusieurs transistors additionnels sont montés en parallèle du premier transistor, les transistors additionnels recevant sur leurs électrodes de commande le même signal que le premier transistor qui peut être le transistor T3 ou T4. De manière plus précise, il est intéressant de prévoir que les transistors additionnels sont montés en parallèles au moyen de plusieurs interrupteurs de connexion 3 connectés pour autoriser ou bloquer le passage d'un courant depuis chaque transistor additionnel associé.

Dans le mode de réalisation de la figure 6, plusieurs transistors sont montés en parallèle du transistor T4 de manière à augmenter la quantité de courant qui circule dans la branche contenant le transistor T4. Comme pour les modes de réalisation précédents, tous les transistors montés en parallèle reçoivent le même signal sur leur électrode de commande, ici le signal $V^-$. Tous les transistors additionnels sont également couplés à un interrupteur de connexion 3 qui est configuré pour autoriser ou bloquer le passage d'un courant additionnel dans la branche de l'amplificateur opérationnel. Les interrupteurs de connexion 3 sont activés au moyen du signal $Com_{T4}$. Comme pour les modes de réalisation précédents, le signal $Com_{T4}$ permet de définir le nombre de transistors montés en parallèle et donc la différence de courant entre les deux branches.

Le mode de réalisation de la figure 7, illustre un autre mode de réalisation où le déséquilibre de l'amplificateur est réalisé au moyen de plusieurs transistors montés en parallèle du transistor T3. Comme pour le mode de réalisation précédent, les multiples transistors montés en parallèle permettent de moduler la quantité de courant qui circule dans cette branche et donc l'écart de courant entre les deux branches. Le nombre de transistors intervenant dans le transfert du courant est défini au moyen des interrupteur de connexion 3 et donc au moyen du signal $Com_{T3}$ qui active les interrupteurs de connexion 3.

Les modes de réalisation des figures 6 et 7 peuvent être combinés. Il est également possible de combiner indifféremment les modes de réalisation illustrés aux figures 4, 5, 6 et 7.

Ces différents modes de réalisation sont particulièrement avantageux car ils permettent de conserver un dispositif compact et facilement réalisable.

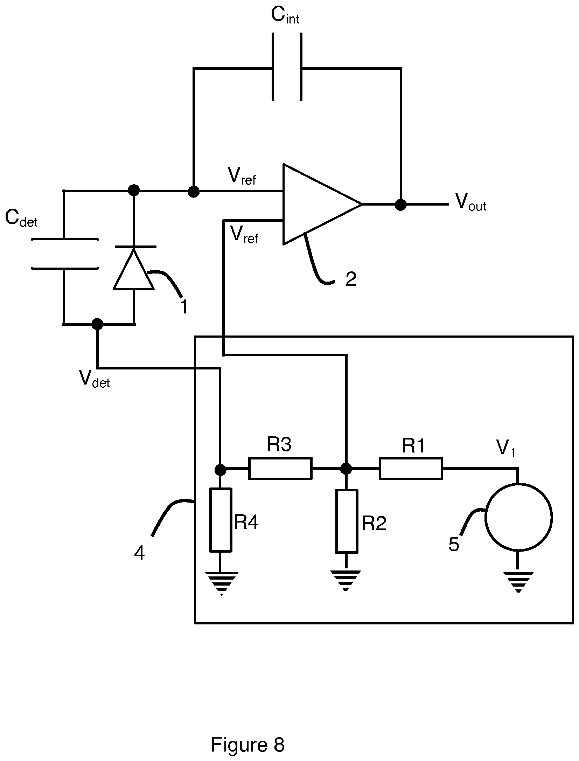

Dans une variante de réalisation illustrée à la figure 8, la même source de tension 4 est utilisée pour délivrer les tensions $V_{ref}$ et $V_{det}$, mais ces deux tensions ne sont pas égales. Par exemple, la tension $V_{ref}$ est obtenue à partir de la tension $V_{det}$ ou inversement. Les deux tensions sont corrélées pour éliminer la composante de bruit. La première source de tension et la deuxième source de tension sont formées au moyen d'une source de tension initiale 5 alimentant un pont résistif délivrant la tension de référence $V_{ref}$ et la tension de détecteur $V_{det}$ différente de la tension de référence $V_{ref}$.

Dans le mode de réalisation illustré à la figure 8, la tension $V_{ref}$ est obtenue à partir de la tension $V_{det}$ au moyen d'un pont résistif. Une source tension initiale 5 est utilisée pour délivrer la tension $V_1$. La tension $V_1$ est appliquée à l'entrée du pont résistif qui délivre les tensions $V_{ref}$ et $V_{det}$.

A titre d'exemple, les résistances R1 et R2 sont montées en série entre la tension $V_1$ et la masse et la tension $V_{ref}$ est délivrée par la borne commune aux résistances R1 et R2. Les résistances R3 et R4 sont montées série et elles sont ensemble montées en parallèle de la résistance R2. La tension $V_{det}$ est délivrée par la borne commune aux résistances R3 et R4 En fonction, des valeurs des résistances R1, R2, R3 et R4, il est possible de définir les tensions $V_{ref}$ et $V_{det}$ par rapport à la tension $V_1$.

A titre d'exemple, la tension de référence $V_{ref}$ peut être égale à 1,5V. La tension de photodétecteur $V_{det}$ peut être décalée de la tension de référence $V_{ref}$ d'environ 200mV.

Pour une source de tension conventionnelle, le niveau de bruit est compris entre 50 et 100$\mu$V.

Pour la détection d'un faible signal, le condensateur d'intégration $C_{int}$ peut être de l'ordre de 50fF. Dans les conditions standards de réalisation, le condensateur parasite $C_{det}$ est d'environ 900fF.

Pour un tel dispositif de détection, il a été observé une nette amélioration du rapport signal sur bruit en utilisant des source de tension $V_{ref}$ et $V_{det}$ corrélées.

La corrélation des sources de tension est avantageuse dans les dispositifs de détection refroidis, par exemple dans les dispositifs de détection ayant une température de fonctionnement inférieure à -50°C car ces dispositifs sont généralement utilisés pour détecter des faibles flux. Il est possible d'utiliser des photodétecteurs réalisés sur un substrat de Mercure, Cadmium et Tellure, mais d'autres matériaux sont également envisageables.

Dans les dispositifs de détections refroidis, les photodétecteurs sont réalisés dans un premier substrat en un premier matériau semi-conducteur et les circuits de lecture sont réalisés dans un deuxième substrat en un deuxième matériau semi-conducteur différent du premier matériau semi-conducteur.

**Revendications**

1. Dispositif de détection, comportant:

    - un photodétecteur (1) configuré pour transformer un signal électromagnétique en un signal électrique représentatif,
    - un amplificateur (2) ayant une première borne d'entrée connectée à une première borne du photodétecteur (1),
    - un condensateur d'intégration ($C_{int}$) connecté à la borne de sortie de l'amplificateur (2) et à la première borne d'entrée de l'amplificateur (2),
    - une première source de tension configurée pour délivrer une tension de référence ($V_{ref}$) à une deuxième borne d'entrée de l'amplificateur (2),
    - une deuxième source de tension configurée pour délivrer une tension de détecteur ($V_{det}$) à une deuxième borne du photodétecteur (1), dispositif de détection **caractérisé en ce que** les première et deuxième sources de tension ($V_{ref}$, $V_{det}$) sont corrélées de manière à corréler les composantes de bruit, dans lequel l'amplificateur (2) est déséquilibré de sorte que la tension sur la première borne d'entrée de l'amplificateur (2) soit décalée de la tension sur la deuxième borne d'entrée de l'amplificateur (2) d'une différence de tension au moins égale à 20mV et/ou dans lequel la première source de tension et la deuxième source de tension sont formées au moyen d'une source de tension initiale (5) alimentant un pont résistif délivrant la tension de référence ($V_{ref}$) et la tension de détecteur ($V_{det}$) différente de la tension de référence ($V_{ref}$).

2. Dispositif de détection selon la revendication 1, **caractérisé en ce que** la différence de tension est comprise entre 50 et 100mV.

3. Dispositif de détection selon l'une des revendications 1 et 2, **caractérisé en ce que** l'amplificateur (2) comporte un miroir de courant muni de deux branches montées en dérivation, l'une des branches présentant des performances électriques différentes de l'autre branche.

4. Dispositif de détection selon la revendication 3, **caractérisé en ce que** l'une des branches du miroir de courant comporte plusieurs transistors additionnels (T1', T1", T1''', T2', T2", T2''', T3', T3", T4', T4") montés en parallèles d'un transistor principal (T1, T2, T3, T4), les transistors additionnels (T1', T1", T1''', T2', T2", T2''', T3', T3", T4', T4") et le transistor principal (T1, T2, T3, T4) recevant tous le même signal sur leur électrode de commande (V+, V⁻).

5. Dispositif de détection selon la revendication 4, **caractérisé en ce que** l'une des branches du miroir de courant comporte plusieurs interrupteurs de connexion (3) connectés pour autoriser ou bloquer le passage d'un courant depuis chaque transistor additionnel associé (T1', T1", T1''', T2', T2", T2''', T3', T3", T4', T4").

6. Dispositif de détection selon l'une des revendications 1 à 5, **caractérisé en ce que** les première et deuxième bornes d'entrée sont connectées respectivement à des électrodes de commande de premier et deuxième transistors (T3, T4) et **en ce que** les premier et deuxième transistors (T3, T4) présentent des performances électriques différentes.

7. Dispositif de détection selon l'une des revendications 1 à 6, **caractérisé en ce que** les première et deuxième bornes d'entrée sont connectées respectivement à des électrodes de commande de premier et deuxième transistors (T3, T4) et **en ce que** plusieurs transistors additionnels (T3', T3", T3''', T4', T4", T4''') sont montés en parallèle du premier transistor (T3, T4), les transistors additionnels (T3', T3", T3''', T4', T4", T4''') recevant sur leurs électrodes de commande le même signal (V+, V⁻) que le premier transistor (T3, T4).

8. Dispositif de détection selon la revendication 7, **caractérisé en ce que** les transistors additionnels (T3', T3", T3''', T4', T4", T4''') sont montés en parallèles au moyen de plusieurs interrupteurs de connexion (3) connectés pour autoriser ou bloquer le passage d'un courant depuis chaque transistor additionnel (T3', T3", T3''', T4', T4", T4''') associé.

9. Dispositif de détection selon l'une des revendication 1 à 8, **caractérisé en ce que** la première source de tension est la deuxième source de tension de sorte que la tension de référence ($V_{ref}$) est égale à la tension de détecteur ($V_{det}$) et **en ce que** l'amplificateur (2) est déséquilibré de sorte que la tension sur la première borne d'entrée de l'amplificateur (2) soit décalée de la tension sur la deuxième borne d'entrée de l'amplificateur (2) d'une différence de tension au moins égale à 20mV.


**Patentansprüche**

1. Detektionsvorrichtung, umfassend:

   - einen Photodetektor (1), der konfiguriert ist, um ein elektromagnetisches Signal in ein repräsentatives elektrisches Signal umzuwandeln,
   - einen Verstärker (2), der eine erste Eingangsklemme aufweist, die an eine erste Klemme des Photodetektors (1) angeschlossen ist,
   - einen Integrationskondensator ($C_{int}$), der an die Ausgangsklemme des Verstärkers (2) und an die erste Eingangsklemme des Verstärkers (2) angeschlossen ist,
   - eine erste Spannungsquelle, die konfiguriert ist, um einer zweiten Eingangsklemme des Verstärkers (2) eine Referenzspannung ($V_{ref}$) bereitzustellen,
   - eine zweite Spannungsquelle, die konfiguriert ist, um einer zweiten Klemme des Photodetektors (1) eine Detektionsspannung ($V_{det}$) bereitzustellen,
   wobei die Detektionsvorrichtung **dadurch gekennzeichnet ist, dass** die erste und die zweite Spannungsquelle ($V_{ref}$, $V_{det}$) derart korreliert sind, um die Rauschkomponenten zu korrelieren, wobei der Verstärker (2) derart unausgeglichen ist, dass die Spannung an der ersten Eingangsklemme des Verstärkers (2) um eine Spannungsdifferenz von mindestens gleich 20 mV von der Spannung an der zweiten Eingangsklemme des Verstärkers (2) verschoben ist und/oder wobei die erste Spannungsquelle und die zweite Spannungsquelle durch eine Anfangsspannungsquelle (5) gebildet sind, die eine Widerstandsbrücke speist, die die Referenzspannung ($V_{ref}$) und die Detektionsspannung ($V_{det}$) bereitstellt, die von der Referenzspannung ($V_{ref}$) verschieden ist.

2. Detektionsvorrichtung nach Anspruch 1, **dadurch gekennzeichnet, dass** die Spannungsdifferenz zwischen 50 und 100 mV beträgt.

3. Detektionsvorrichtung nach einem der Ansprüche 1 und 2, **dadurch gekennzeichnet, dass** der Verstärker (2) einen Stromspiegel aufweist, der mit zwei Zweigen ausgestattet ist, die in Abzweigung geschaltet sind, wobei einer der Zweige elektrische Leistungen aufweist, die von dem anderen Zweig verschieden sind.

4. Detektionsvorrichtung nach Anspruch 3, **dadurch gekennzeichnet, dass** einer der Zweige des Stromspiegels mehrere zusätzliche Transistoren (T1', TI", T1''', T2', T2", T2''', T3', T3", T4', T4") aufweist, die mit einem Haupttransistor (T1, T2, T3, T4) parallel geschaltet sind, wobei die zusätzlichen Transistoren (T1', T1", T1''', T2', T2", T2''', T3', T3", T4', T4") und der Haupttransistor (T1, T2, T3, T4) alle das gleiche Signal an ihrer Steuerelektrode (V⁺, V⁻) empfangen.

5. Detektionsvorrichtung nach Anspruch 4, **dadurch gekennzeichnet, dass** einer der Zweige des Stromspiegels mehrere Verbindungsschalter (3) aufweist, die angeschlossen sind, um den Durchfluss eines Stroms von jedem zugeordneten zusätzlichen Transistor (T1', T1", T1''', T2', T2", T2''', T3', T3", T4', T4") zu gestatten oder zu blockieren.

6. Detektionsvorrichtung nach einem der Ansprüche 1 bis 5, **dadurch gekennzeichnet, dass** die erste und die zweite Eingangsklemme jeweils an Steuerelektroden des ersten und des zweiten Transistors (T3, T4) angeschlossen sind und dadurch, dass der erste und der zweite Transistor (T3, T4) verschiedene elektrische Leistungen aufweisen.

7. Detektionsvorrichtung nach einem der Ansprüche 1 bis 6, **dadurch gekennzeichnet, dass** die erste und die zweite Eingangsklemme jeweils an Steuerelektroden des ersten und des zweiten Transistors (T3, T4) angeschlossen sind und dadurch, dass mehrere zusätzliche Transistoren (T3', T3", T3''', T4', T4", T4''') mit dem ersten Haupttransistor (T3, T4) parallel geschaltet sind, wobei die zusätzlichen Transistoren (T3', T3", T3''', T4', T4", T4''') an ihren Steuerelektroden das gleiche Signal (V+, V-) wie der erste Transistor (T3, T4) empfangen.

8. Detektionsvorrichtung nach Anspruch 7, **dadurch gekennzeichnet, dass** die zusätzlichen Transistoren (T3', T3", T3''', T4', T4", T4''') mit Hilfe von mehreren Verbindungsschaltern (3) parallel geschaltet sind, die angeschlossen sind, um den Durchfluss eines Stroms von jedem zugeordneten zusätzlichen Transistor (T3', T3", T3''', T4', T4", T4''') zu gestatten oder zu blockieren.

9. Detektionsvorrichtung nach einem der Ansprüche 1 bis 8, **dadurch gekennzeichnet, dass** die erste Spannungsquelle und die zweite Spannungsquelle derart sind, dass die Referenzspannung ($V_{ref}$) gleich der Detektionsspannung ($V_{det}$) ist und dass der Verstärker (2) derart unausgeglichen ist, dass die Spannung an der ersten Eingangsklemme des Verstärkers (2) um eine Spannungsdifferenz von mindestens gleich 20 mV von der Spannung an der zweiten Eingangsklemme des Verstärkers (2) verschoben ist.

**Claims**

1. A detection device, comprising:

   - a photodetector (1) configured to transform an electromagnetic signal into a representative electric signal,
   - an amplifier (2) having a first input terminal connected to a first terminal of the photodetector (1),
   - an integration capacitor ($C_{int}$) connected to the output terminal of the amplifier (2) and to the first input terminal of the amplifier (2),
   - a first voltage source configured to deliver a reference voltage ($V_{ref}$) to a second input terminal of the amplifier (2),
   - a second voltage source configured to deliver a detector voltage ($V_{det}$) to a second terminal of the photodetector (1),
   detection device **characterized in that** the first and second voltage sources ($V_{ref}$, $V_{det}$) are correlated so as to correlate the noise components, wherein the amplifier (2) is unbalanced so that the voltage on the first input terminal of the amplifier (2) is offset from the voltage on the second input terminal of the amplifier (2) by a voltage difference at least equal to 20mV and/or wherein the first voltage source and the second voltage source are formed by means of an initial voltage source (5) supplying a resistive bridge delivering the reference voltage ($V_{ref}$) and the detector voltage ($V_{det}$) different from the reference voltage ($V_{ref}$).

2. The detection device according to claim 1, **characterized in that** the voltage difference is comprised between 50 and 100mV.

3. The detection device according to one of claims 1 and 2, **characterized in that** the amplifier (2) comprises a current mirror provided with two shunt-connected branches, one of the branches presenting different electric performances from the other branch.

4. The detection device according to claim 3, **characterized in that** one of the branches of the current mirror comprises several additional transistors (T1', T1", T1''', T2', T2", T2''' T3', T3", T4', T4") connected in parallel to a main transistor (T1, T2, T3, T4), the additional transistors (T1', T1", T1''', T2', T2", T2''', T3', T3", T4', T4") and the main transistor (T1, T2, T3, T4) all receiving the same signal on their control electrode ($V^+$, $V^-$).

5. The detection device according to claim 4, **characterized in that** one of the branches of the current mirror comprises several connecting switches (3) connected to enable or to disable the flow of a current from each associated additional transistor (T1', T1", T1''', T2', T2", T2''', T3', T3", T4', T4").

6. The detection device according to one of claims 1 to 5, **characterized in that** the first and second input terminals are respectively connected to control electrodes of first and second transistors (T3, T4) and **in that** the first and second transistors present different electric performances.

7. The detection device according to one of claims 1 to 6, **characterized in that** the first and second input terminals are respectively connected to control electrodes of first and second transistors (T3, T4) and **in that** several additional transistors (T3', T3", T3''', T4', T4", T4''') are connected in parallel to the first transistor (T3, T4), the additional transistors (T3', T3", T3''', T4', T4", T4''') receiving the same signal ($V^+$, $V^-$) as the first transistor (T3, T4) on their control electrodes.

8. The detection device according to claim 7, **characterized in that** the additional transistors (T3', T3", T3''', T4', T4", T4''') are connected in parallel by means of several connecting switches (3) connected to enable or to disable the flow of a current from each associated additional transistor (T3', T3", T3''', T4', T4", T4''').

9. The detection device according to one of claims 1 to 8, **characterized in that** the first voltage source is the second voltage source so that the reference voltage ($V_{ref}$) is equal to the detector voltage ($V_{det}$) and **in that** the amplifier (2) is unbalanced so that the voltage on the first input terminal of the amplifier (2) is offset from the voltage on the second input terminal of the amplifier (2) by a voltage difference at least equal to 20mV.

Figure 1

Figure 2

Figure 3

Figure 4

3

Com$_{T1}$

T1''''  T1''  T1'  T1  T2

V$_{out}$

V$^+$  T3  T4  V$^-$

Figure 5

T1  T2

V$_{out}$

3

Com$_{T4}$

V$^+$  T3  T4  V$^-$

T4'  T4''

Figure 6

Figure 7

Figure 8

**EP 3 057 311 B1**

## RÉFÉRENCES CITÉES DANS LA DESCRIPTION

**Documents brevets cités dans la description**

- US 2013264490 A1